(19) Europäisches Patentamt
European Patent Office
Office européen des brevets

(11) **EP 3 414 558 B1**

(12) **EUROPÄISCHE PATENTSCHRIFT**

(45) Veröffentlichungstag und Bekanntmachung des Hinweises auf die Patenterteilung:
**29.12.2021 Patentblatt 2021/52**

(51) Int Cl.:
*G01N 25/52* (2006.01)   *F28F 13/00* (2006.01)
*H01L 23/38* (2006.01)   *H05K 7/20* (2006.01)

(21) Anmeldenummer: **17707157.8**

(22) Anmeldetag: **07.02.2017**

(86) Internationale Anmeldenummer:
**PCT/AT2017/000006**

(87) Internationale Veröffentlichungsnummer:
**WO 2017/136861 (17.08.2017 Gazette 2017/33)**

(54) **VERFAHREN ZUM TEMPERIEREN EINER MESSPROBE**

METHOD FOR CONTROLLING THE TEMPERATURE OF A TEST SAMPLE

PROCÉDÉ DE MISE EN TEMPÉRATURE D'UN ÉCHANTILLON D'ESSAI

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.02.2016 AT 612016**

(43) Veröffentlichungstag der Anmeldung:
**19.12.2018 Patentblatt 2018/51**

(73) Patentinhaber: **Grabner Instruments Messtechnik GmbH**
**1220 Wien (AT)**

(72) Erfinder: **LUTZ, Josef**
**2471 Rohrau (AT)**

(74) Vertreter: **Keschmann, Marc**
**Haffner und Keschmann Patentanwälte GmbH**
**Schottengasse 3a**
**1010 Wien (AT)**

(56) Entgegenhaltungen:
**WO-A1-2012/017009      US-A1- 2005 006 372**
**US-A1- 2010 227 383      US-A1- 2015 233 614**

**Beschreibung**

Eine Vorrichtung zum Temperieren einer Messprobe in einer Messeinrichtung zum Messen von Stoffeigenschaften der Messprobe umfassend eine Messzelle zur Aufnahme der Messprobe, wenigstens ein Temperierungselement und ein mit dem Temperierungselement wärmeübertragend gekoppeltes Wärmespeicherelement, wobei Mittel zur Änderung des Wärmeleitwiderstandes zwischen dem Wärmespeicherelement und der Messzelle vorgesehen sind, um das Wärmespeicherelement und die Messzelle wahlweise voneinander wärmeübertragend zu entkoppeln oder miteinander wärmeübertragend zu koppeln, wird offenbart.

Die Erfindung betrifft ein Verfahren zum Messen von Stoffeigenschaften einer Messprobe und anschließendem Abkühlen der Messprobe mittels der offenbarten Vorrichtung.

In vielen Fällen müssen bei Qualitätsüberprüfungen von Stoffen, bei der Definition von Materialkonstanten oder bei Zertifizierungen die entsprechenden Messungen bei vorgegebenen Temperaturen der Messprobe durchgeführt werden oder es muss die Temperatur der Probe während des Messvorgangs variiert werden. Wenn die erforderlichen Messungen bei Temperaturen durchgeführt werden sollen, die deutlich oberhalb oder unterhalb der Raumtemperatur liegen, ist es üblich die entsprechenden Messvorrichtungen mit einem Kühl- und/oder Heizaggregat zu versehen. Die Messprobe wird somit bei Raumtemperatur in die Messvorrichtung gegeben, in der Messvorrichtung auf die erforderliche Temperatur gebracht, die Messung durchgeführt und die Probe danach wieder auf Raumtemperatur oder in den Bereich der Raumtemperatur gebracht, um diese gefahrlos aus der Messvorrichtung holen zu können. Obwohl die Temperierschritte für den Messvorgang in vielen Fällen wenig Bedeutung haben, sind sie für den Durchsatz von Proben (Messungen pro Stunde) von essentieller Bedeutung, weil sie bei Temperaturen weit unterhalb bzw. weit über der Raumtemperatur vergleichsweise lange dauern können.

Bei herkömmlichen Ausführungen von Kühlaggregaten für Messproben bzw. für die zur Aufnahme der Messproben vorgesehene Messzelle werden insbesondere im Falle portabler Messgeräte Peltier-Elemente als Temperierungs- bzw. Kühlelement verwendet. Eine effiziente Kühlung erhält man, wenn das wenigstens eine Peltier-Element die Probe bzw. die Messzelle direkt kontaktiert und ein geringer Wärmeübergangswiderstand erreicht werden kann.

Für den Aufheizvorgang der Messzelle können entweder zusätzliche Heizpatronen in der Messzelle oder das Peltier-Element selbst verwendet werden, indem die Polarität der angelegten Spannungsversorgung umgekehrt wird.

Die Beschränkung der Verwendung von Peltier-Elementen als Heiz- und Kühlelemente besteht vor allem in der maximal zulässigen Temperatur solcher Elemente von üblicherweise 120°C (in wenigen Fällen bis 200°C). Bei Überschreitung dieser Grenztemperatur werden die Peltier-Elemente zerstört bzw. zumindest die Lebensdauer stark reduziert, wenn die maximale Temperatur nicht zu stark überschritten wird. Für Anwendungen mit einer Zellentemperatur von über 200°C muss daher oftmals eine andere Kühltechnologie eingesetzt werden oder man trennt das Peltier-Element von der Messzelle thermisch so weit, dass die maximale Temperatur am Peltier-Element nicht überschritten wird.

Im Stand der Technik sind verschiedene Möglichkeiten beschrieben worden, mit denen eine Überschreitung der Grenztemperatur verhindert werden kann. Eine dieser Möglichkeiten ist in der EP 540886 B1 gezeigt und liegt in der Verwendung einer "thermischen Diode". Zwischen dem Peltier-Element und der Messzelle wird eine Flüssigkeitsschicht eingebaut. Liegt die Verdampfungstemperatur der Flüssigkeit unterhalb der kritischen Temperatur des Peltier-Elements, kann letzteres nicht überhitzt werden, da der Dampf zwischen heißer Messzelle und Peltier-Element ein schlechter Wärmeleiter ist.

Eine andere Möglichkeit (WO 2012/017009 A1) besteht darin, die Kühleinheit (Peltier-Element samt zugeordnetem Kühlkörper) mechanisch von der Messzelle zu trennen, bevor das Peltier-Element während des Kühlvorganges die Grenztemperatur überschreitet. Der Kühlvorgang kann durch eine unterbrochene Kühlung beschleunigt werden, indem die Kühleinheit zuerst abgekühlt und dann mit der Messzelle in mechanischen Kontakt gebracht wird. Überschreitet die Temperatur des Peltier-Elements auf Grund des von der Messzelle kommenden Wärmeflusses einen maximalen Wert, wird der mechanische Kontakt wieder unterbrochen und die kältere Seite der Kühleinheit wieder abgekühlt. Dieser Vorgang wird zyklisch wiederholt bis die maximale Temperatur des Peltier-Elements nicht mehr erreicht wird und die Kühleinheit zum Zwecke der weiteren Kühlung in konstantem Kontakt mit der Probe bzw. Messzelle bleiben kann.

Der wesentliche Nachteil einer fixen Kontaktierung der Kühleinheit mit der Probe bzw. Messzelle besteht in der Limitierung der Temperatur und einer hohen Spitzenleistung für die Kühlung während der Kühlphase.

Die beschriebenen Lösungen nach dem Stand der Technik sind mit den folgenden Nachteilen verbunden. Im Falle der "thermischen Diode" ist vor allem die Kühlung der Probe bzw. der Messzelle bei hohen Temperaturen sehr langsam, da die "thermische Diode" nur wenig Wärmeleistung in das Peltier-Element transportiert. Für einen schnelleren Kühlvorgang müsste eine zusätzliche Kühlmethode für hohe Temperaturen vorgesehen werden, was meist aus Platz- und Kostengründen nicht sinnvoll möglich ist.

Beim System mit "unterbrochener Kühlung" stellt vor allem der mechanische Aufwand für die Bewegung der Kühleinheit einen großen Nachteil betreffend Kosten und das für die Mechanik und den Antrieb notwendige Volumen dar. Des Weiteren ist die Qualität der Oberflächen und deren Veränderungen über die Lebensdauer ein kritischer Faktor für die Effizienz der Kühlung. Zusätzlich ist wie auch beim System der "thermischen Diode" und beim System der fixen Kontaktierung eine hohe Spitzenleistung während des Kühlvorganges erforderlich, was die gesamte Kühleinheit sehr groß macht.

Die vorliegende Erfindung zielt daher darauf ab, die oben genannten Nachteile zu überwinden und ein Verfahren zur Temperierung einer Messprobe zu schaffen, mit welchem die Überhitzung eines Peltier-Elements verhindert und die Geschwindigkeit der Temperierung, insbesondere Kühlung der Messprobe erhöht werden kann.

Zur Lösung dieser Aufgabe besteht die Erfindung bei einem Verfahren mit einer Vorrichtung der eingangs genannten Art im wesentlichen darin, dass das Verhältnis der Wärmekapazität des Wärmespeicherelements zur Wärmekapazität der Messzelle mindestens 2:1, vorzugsweise mindestens 5:1 ist.

Die Temperierung der Messzelle samt Messprobe erfolgt somit unter Verwendung eines Wärmespeicherelements, das eine relativ hohe Wärmekapazität aufweist. Die Wärmeübertragung erfolgt im Falle einer Erwärmung der Messzelle von dem Temperierungselement auf das Wärmespeicherelement und vom Wärmespeicherelement auf die Messzelle. Im Falle der Abkühlung der Messzelle erfolgt die Wärmeübertragung vom Wärmespeicherelement auf das Temperierungselement und von der Messzelle auf das Wärmespeicherelement. Das Wärmespeicherelement wird zu diesem Zweck vom Temperierungselement vorgeheizt oder vorgekühlt, wobei die Erwärmung bzw. Abkühlung der Messzelle durch wärmeübertragende Kopplung des Wärmespeicherelements mit der Messzelle und den dadurch hervorgerufenen Temperaturausgleich zwischen diesen erreicht wird.

Bevorzugt wird das erfindungsgemäße Wärmespeicherelement für die Kühlung der Messzelle verwendet. Für den Fall, dass die Messzelle für die Durchführung der erforderlichen Messungen zuerst erwärmt und nach Abschluss der Messungen wieder abgekühlt wird, kann nicht nur der Kühlvorgang, sondern auch die Erwärmung über den Wärmespeicher erfolgen. Dies hat jedoch den Nachteil, dass man das Wärmespeicherelement dann rasch mit sehr hohen Temperaturänderungen beaufschlagen müsste, was vor allem bei der Kühlung zu Problemen führen kann, wenn man sowohl für den Vorrang der Erwärmung als auch für den Vorgang der Abkühlung dasselbe Wärmespeicherelement verwendet. Bevorzugt ist daher eine Ausbildung, bei der zwei verschiedene Wärmespeicherelemente vorgesehen sind, eines wird für den Vorgang der Erwärmung entsprechend vorgewärmt und das andere für den Vorgang des Kühlens entsprechend vorgekühlt. Die Messzelle kann wahlweise mit dem einen Wärmespeicherelement oder mit dem anderen Wärmespeicherelement wärmeübertragend gekoppelt werden.

Alternativ kann die Erwärmung der Messzelle in herkömmlicher Weise über Heizelemente direkt in der Messzelle durchgeführt werden.

Die Wärmekapazität des Wärmespeicherelements wird so gewählt den, dass die Temperierung der Messzelle in einem einzigen Schritt, d.h. im Gegensatz zur Ausbildung gemäß der WO 2012/017009 A1 ohne Unterbrechung des Temperierungsvorganges, erzielt werden kann. Im Anwendungsfall der Kühlung der Messzelle ist es außerdem möglich, das System durch geeignete Wahl einer hohen Wärmekapazität des Wärmespeicherelements so auszulegen, dass die maximale Temperatur des Wärmespeichers nach Beendigung des Kühlvorganges, d.h. nach der Wärmeübertragung von der Messzelle auf den Wärmespeicher, insbesondere bei Erreichen eines vollständigen Temperaturausgleichs zwischen der Messzelle und dem Wärmespeicherelement, unter der kritischen Temperatur des Peltier-Elements liegt. Eine solche Auslegung gelingt insbesondere dann, wenn das Verhältnis der Wärmekapazität des Wärmespeicherelements zur Wärmekapazität der Messzelle mindestens 2:1, vorzugsweise mindestens 5:1 beträgt.

Um ein Vorkühlen bzw. Vorheizen des Wärmespeicherelements zu ermöglichen, ist eine bevorzugt vollständige Trennung der Messzelle von der das Temperierungselement und das Wärmespeicherelement umfassenden Temperierungseinrichtung vorgesehen. Die wärmeübertragende Kopplung der Messzelle mit dem Wärmespeicherelement und damit der eigentliche Temperierungsvorgang der Messzelle erfolgt bevorzugt erst nach dem Vorkühlen bzw. Vorheizen. Das wahlweise wärmeübertragende Koppeln und Entkoppeln der Messzelle und des Wärmespeicherelements erfolgt hierbei durch Änderung des Wärmeleitwiderstandes zwischen der Messzelle und dem Wärmespeicherelement.

Der Vorteil der Auftrennung zwischen der Messzelle und der das Temperierungselement und das Wärmespeicherelement umfassenden Temperierungseinrichtung sowie der Vorteil der hohen Speicherkapazität des Wärmespeicherelements liegt darin, dass die Geschwindigkeit des Kühlvorganges nicht mehr von der maximalen Leistung der Kühltechnologie abhängt (z.B. Peltier-Elemente). Die Geschwindigkeit bis zum Ausgleich der Temperaturen der Messzelle und des Wärmespeicherelements wird fast ausschließlich durch die maximale Wärmeübertragung zwischen der Messzelle und dem Wärmespeicherelement bestimmt.

Die Gleichgewichtstemperatur $T_{eq}$ zwischen der Messzelle und dem Wärmespeicherelement ergibt sich im Idealfall (keine Verluste und nichtlinearen Effekte) durch:

$$T_{eq} = (C_{MZ}*T_{MZ} + C_{WS}*T_{WS})/(C_{MZ} + C_{WS})$$

wobei $C_{MZ}$, $C_{WS}$ für die Wärmekapazitäten von Messzelle und Wärmespeicherelement und $T_{MZ}$, $T_{WS}$ für die Temperaturen der Messzelle und des Wärmespeicherelements vor dem Wärmetransport stehen.

Idealerweise liegt die Temperatur $T_{WS}$ des Wärmespeicherelements vor dem Start des Wärmetransportes so tief, dass die Gleichgewichtstemperatur $T_{eq}$ unterhalb jener Temperatur liegt, die für die nächsten Prozessschritte notwendig ist. Damit ist eine weitere Kühlung des gesamten Systems mittels des Temperierungselements, insbesondere des Peltier-Elements nicht mehr notwendig und der gesamte Kühlvorgang kann in der kürzest möglichen Zeit abgeschlossen werden.

Parallel zu den folgenden Prozessschritten inklusive der nächsten Messung kann das Wärmespeicherelement in von der Probe bzw. Messzelle wärmeübertragend entkoppeltem Zustand durch das Temperierungselement, insbesondere Peltier-Element, auf die Ausgangstemperatur für den nächsten Kühlvorgang gebracht werden. Da die Zeit zwischen den Kühlvorgängen in den überwiegenden Fällen der Anwendungen bei Messungen deutlich länger ist als die Zeit für den Kühlvorgang selbst, ist die notwendige Kühlleistung deutlich geringer. Das Verhältnis der kontinuierlichen Kühlleistung des Wärmespeichers $P_{WS}$ zur notwendigen Kühlleistung während des Kühlvorganges für die Messzelle $P_{MZ}$ ergibt sich aus dem Verhältnis der erforderlichen Kühlzeit $t_K$ zur gesamten Zeit für einen Messzyklus $t_M$.

$$E_W = P_{WS} * t_M = P_{MZ} * t_K$$

$E_W$ entspricht der übertragenen Wärmeenergie.

Mit Hilfe der offenbarten Vorrichtung kann ein Verfahren durchgeführt werden, das Gegenstand der vorliegenden Erfindung ist. Das erfindungsgemäße Verfahren zum Messen von Stoffeigenschaften einer Messprobe und anschließendem Abkühlen der Messprobe umfasst die Schritte:

a) Messen der Stoffeigenschaften der Messprobe bei einer Messtemperatur,
b) vor und/oder während Schritt a): Abkühlen, im wärmeübertragend von der Messzelle entkoppelten Zustand, des Wärmespeicherelements mit Hilfe des Temperierungselements,
c) nach Schritt a) und b): Reduzieren des Wärmeleitwiderstandes zwischen dem Wärmespeicherelement und der Messzelle, um das Wärmespeicherelement und die Messzelle miteinander wärmeübertragend zu koppeln,
d) ununterbrochene Wärmeübertragung von der Messzelle auf das Wärmespeicherelement, wobei die Messprobe von der Messtemperatur auf eine für die Entnahme der Messprobe geeignete Temperatur gekühlt wird,
e) Entnahme der Messprobe.

Insbesondere wird das Verhältnis der Wärmekapazität des Wärmespeicherelements zur Wärmekapazität der Messzelle ggf. samt Messprobe dabei so gewählt, dass die Temperatur des Wärmespeicherelements am Ende von Schritt d) 200°C, vorzugsweise 160°C, besonders bevorzugt 120°C nicht überschreitet.

Die Wärmeübertragung zwischen dem Wärmespeicherelement und der Messzelle kann grundsätzlich beliebig erfolgen, wie z.B. durch erzwungene bzw. natürliche Konvektion, Wärmestrahlung oder Wärmeleitung oder durch Kombinationen davon. Die natürliche Konvektion kommt aufgrund der vergleichsweise geringen Energieübertragung in den meisten Fällen jedoch nicht in Frage. Die Wärmeübertragung mittels Wärmestrahlung wird bei hohen Temperaturen ($P \cdot \alpha \cdot T^4$) sehr effizient, für niedrigere Temperaturen, wie z.B. bei Kühlvorgängen unter 100°C ist die Effizienz eher gering.

Bevorzugt erfolgt die Wärmeübertragung zwischen der Messzelle und dem Wärmespeicherelement über ein dazwischen angeordnetes Wärmeübertragungselement, mit welchem der Wärmeleitwiderstand zwischen der Messzelle und dem Wärmespeicherelement eingestellt bzw. geändert werden kann.

Gemäß einer bevorzugten Ausführung umfassen die Mittel zur Änderung des Wärmeleitwiderstandes einen Antrieb zum Bewegen des Wärmespeicherelements, der Messzelle und/oder eines zwischen diesen angeordneten Wärmeübertragungselements zwischen einer ersten Position, in der das Wärmespeicherelement und die Messzelle in wärmeleitendem Kontakt stehen, und einer zweiten Position, in der das Wärmespeicherelement und die Messzelle voneinander wärmeleitend getrennt sind. Die Wärmeübertragung erfolgt hierbei hauptsächlich durch Wärmeleitung.

Gemäß einer alternativen Ausführung ist ein das Wärmespeicherelement und die Messzelle miteinander verbindender Fluid-, insbesondere Flüssigkeitskreislauf als Wärmeübertragungselement vorgesehen, wobei die Mittel zur Änderung des Wärmeleitwiderstandes eine im Fluidkreislauf angeordnete Pumpe umfassen. Der Wärmetransport mittels Flüssigkeit in einem Rohrsystem funktioniert hierbei ähnlich einer Heizungsanlage und umfasst eine Kombination von erzwungener Konvektion und Wärmeleitung.

Eine weitere bevorzugte Ausbildung sieht vor, dass das Temperierungselement ein thermo-elektrisches Element, insbesondere ein Peltier-Element umfasst oder als solches ausgebildet ist.

Eine bevorzugte Anwendung der Erfindung liegt in einem Verfahren zur Messung des Flammpunktes einer Messprobe. Die Ausbildung ist in diesem Zusammenhang bevorzugt derart getroffen, dass die Vorrichtung zur Messung des Flammpunktes einer flüssigen oder festen Messprobe, insbesondere eines Erdölprodukts, ausgebildet ist, wobei die Messzelle eine Messkammer zur Aufnahme der Messprobe umfasst, welche vorzugsweise aus einer Messwanne sowie einem Deckel gebildet ist und welche mit einer eine Funkenstrecke aufweisenden elektrischen Zündung, wenigstens einem Temperaturfühler und einer Druckmesseinrichtung versehen ist, wobei weiters eine Steuervorrichtung zum Steuern der Temperierungseinrichtung, der Zündung und der Anpressvorrichtung und zum Erfassen der Messwerte der Temperaturfühler und der Druckmesseinrichtung vorgesehen ist.

Der Flammpunkt einer Substanz wird bei Transport- und Sicherheitsvorschriften verwendet, um entflammbare und explosive Materialien zu definieren und gibt über das Vorhandensein von leichtflüchtigen und entflammbaren Komponenten in einer schwer flüchtigen und nichtbrennbaren Substanz Auskunft.

Nach ASTM ist der Flammpunkt als die niedrigste Temperatur, korrigiert auf barometrischen Luftdruck von 101,3 kPa definiert, bei welcher sich durch das Anlegen einer Testflamme der Dampf der Probe entflammt, wobei eine Flamme entsteht, welche selbst über die Oberfläche der Probe wandert und mindestens zwei Drittel der Oberfläche bedeckt.

Zur Messung des Flammpunkts wird eine Messprobe in die Messzelle gegeben und die Messzelle samt Messprobe auf eine vorgegebene Temperatur aufgeheizt, welche mit Sicherheit unter der erwarteten Flammpunkttemperatur liegt. Danach wird die Temperatur der Messzelle samt Messprobe langsam weiter erhöht und in konstanten Temperaturabständen eine Zündung vorgenommen. Unmittelbar nach der Zündung wird der Druckanstieg über eine Druckmesseinrichtung, welche vorzugsweise als piezoresistiver Druckgeber ausgebildet ist, in der Messzelle gemessen. Die Flammpunkttemperatur gibt ein weiterer Temperaturfühler an.

Im Rahmen der Erfindung wird unter der Wärmekapazität eines Körpers das Verhältnis der ihm zugeführten Wärme zu der damit bewirkten Temperaturerhöhung verstanden: $C = dQ/dT$. Die Einheit der Wärmekapazität ist J/K. Das Wärmespeicherelement gemäß der Erfindung ist somit jeglicher Körper, der in der Lage ist, seine Temperatur unter Wärmezufuhr zu erhöhen bzw. seine Temperatur unter Wärmeabfuhr zu verringern. Für homogene Körper kann man die Wärmekapazität berechnen als das Produkt der Masse und der auf die Masse bezogenen spezifischen, materialabhängigen Wärmekapazität c des betreffenden Stoffs. Besonders geeignet im Rahmen der Erfindung sind Wärmespeicherelemente mit einer hohen spezifischen Wärmekapazität von bevorzugt > 0,25, besonders bevorzugt > 0,45 kJ $\cdot$ kg$^{-1}$ $\cdot$ K$^{-1}$. Das Wärmespeicherelement besteht hierbei vorzugsweise aus einem Metall, wie z.B. Kupfer, Messing, Stahl, Aluminium.

Die Erfindung wird nachfolgend anhand eines in der Zeichnung schematisch dargestellten Ausführungsbeispiels näher erläutert. In dieser zeigen Fig. 1 eine allgemeine Darstellung der Erfindung, Fig. 2 eine erste Ausführungsform der Erfindung und Fig. 3 eine zweite Ausführungsform der Erfindung.

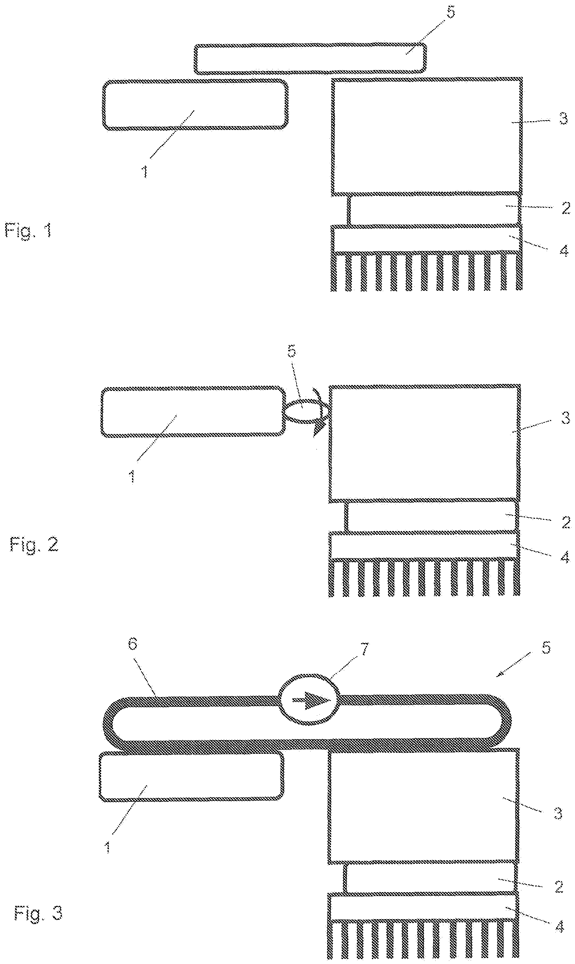

In Fig. 1 ist eine Messzelle mit 1 bezeichnet, welche im Anwendungsfall eine Messprobe z.B. einer Flüssigkeit enthält, deren Stoffeigenschaft, z.B. Flammpunkt, bestimmt werden soll. Zur Bestimmung des Flammpunkts wird die Messprobe auf eine bestimmte Temperatur erwärmt und danach die erforderlichen Messungen vorgenommen. Danach soll die Messprobe soweit abgekühlt werden, dass die Messprobe aus der Messvorrichtung entnommen werden kann. Zur Abkühlung der Messzelle bzw. Messprobe umfasst die Vorrichtung ein Temperierungselement 2, welches im vorliegenden Ausführungsbeispiel als Peltier-Element ausgebildet ist. Im Betrieb entzieht das Peltier-Element 2 dem Wärmespeicherelement 3 Wärme und führt diese über den Kühlkörper 4 ab. Das Wärmespeicherelement 3 steht dabei in unmittelbarem wärmeleitenden Kontakt mit dem Peltier-Element 2. Um den Kühlvorgang zur Kühlung der Messprobe zu beschleunigen, wird das Wärmespeicherelement 3 bereits während des oben beschriebenen Messverfahrens oder davor vorgekühlt. Während der Vorkühlung sind die Messzelle 1 und das Wärmespeicherelement 3 voneinander entkoppelt, sodass im Wesentlichen keine Wärmeübertragung zwischen diesen erfolgt. Sobald die erforderlichen Messungen abgeschlossen sind, werden die Messzelle 1 und das Wärmespeicherelement 3 so miteinander gekoppelt, dass eine Wärmeübertragung stattfindet und die Messzelle 1 abgekühlt wird. Zu diesem Zweck sind Mittel zur Änderung des Wärmeleitwiderstandes zwischen dem Wärmespeicherelement 3 und der Messzelle 1 vorgesehen, um das Wärmespeicherelement 3 und die Messzelle 1 wahlweise voneinander wärmeübertragend zu entkoppeln oder miteinander wärmeübertragend zu koppeln. Die Mittel zur Änderung des Wärmeleitwiderstandes sind im vorliegenden Ausführungsbeispiel als Wärmeübertragungselement 5 mit verstellbaren Wärmeübertragungseigenschaften ausgebildet.

Der Wärmetransport zwischen der Messzelle 1 und dem Wärmespeicherelement 3 kann mittels Wärmeleitung über Festkörper bewerkstelligt werden. In diesem Fall muss ein mechanischer Kontakt zwischen der Messzelle 1 und dem Wärmespeicherelement 3 hergestellt werden. Dies kann entweder durch die Bewegung einer Platte, von Keilen oder durch die Rotation einer Ellipse erfolgen. In allen Fällen muss ein mechanischer Teil mit guter Wärmeleitfähigkeit (z.B.: Metall) bewegt werden und mit beiden Elementen in Kontakt gebracht werden. Eine weitere Möglichkeit besteht darin, die Messzelle 1 oder das Wärmespeicherelement 3 durch eine entsprechende Bewegung einer oder beider Komponenten direkt miteinander in Kontakt zu bringen.

Beim Ausführungsbeispiel gemäß Fig. 2 ist das Wärmeübertragungselement 5 von einem ellipsenförmigen Stab gebildet. Durch eine einfache Drehung des Stabes mit ellipsenförmigen Querschnitt kann der Wärmetransport zwischen dem Wärmespeicherelement 3 und der Messzelle 1 ein- und ausgeschalten werden. Die transportierte Energie hängt im Wesentlichen von der mittleren Länge, dem mittleren Querschnitt des Transportkanals (Stab) und der Temperaturdifferenz zwischen der Messzelle 1 und dem Wärmespeicherelement 3 ab.

Bei der alternativen Ausführungsform gemäß Fig. 3 erfolgt der Wärmetransport über eine Flüssigkeit. In diesem Fall wird eine Flüssigkeit in einem geschlossenen Rohrsystem 6 mittels einer Pumpe 7 vom Wärmespeicherelement 3 zur Messzelle 1 und zurück transportiert (erzwungene Konvektion). Die von der Flüssigkeit an der Messzelle 1 aufgenommene Wärmeenergie wird am Wärmespeicherelement 3 wieder abgegeben, solange dessen Temperatur geringer ist als die der Flüssigkeit. Die übertragbare Wärmeenergie hängt bei gegebenen Materialparametern im Wesentlichen vom Volumenstrom der Flüssigkeit ab.

Ähnlich wie Flüssigkeiten können auch Gase (Luft) für den Transport herangezogen werden. Allerdings ist aufgrund der geringen Wärmekapazität von Gasen ein deutlich höherer Volumenfluss notwendig, was zu großen Kühlkörpern an den einzelnen Komponenten führt.

Gemeinsam ist allen beschriebenen Ausführungsformen, dass das Wärmespeicherelement 3 eine hohe Wärmekapazität aufweist, sodass das Verhältnis der Wärmekapazität des Wärmespeicherelements 3 zur Wärmekapazität der Messzelle 1 mindestens 2:1, vorzugsweise mindestens 5:1 ist. Dadurch wird erreicht, dass die Messzelle 1 bei entsprechend vorgekühltem Wärmespeicherelement 3 rasch abgekühlt wird und das Wärmespeicherelement 3 dabei nicht eine Temperatur erreicht, die über der Grenztemperatur des Peltier-Elements 2 liegt.

## Patentansprüche

1. Verfahren zum Messen von Stoffeigenschaften einer Messprobe und anschließenden Abkühlen der Messprobe mittels einer Vorrichtung zum Temperieren einer Messprobe in einer Messeinrichtung zum Messen von Stoffeigenschaften der Messprobe umfassend eine Messzelle (1) zur Aufnahme der Messprobe, wenigstens ein Temperierungselement (2) und ein mit dem Temperierungselement (2) wärmeübertragend gekoppeltes Wärmespeicherelement (3), wobei Mittel zur Änderung des Wärmeleitwiderstandes zwischen dem Wärmespeicherelement (3) und der Messzelle (1) vorgesehen sind, um das Wärmespeicherelement (3) und die Messzelle (1) wahlweise voneinander wärmeübertragend zu entkoppeln oder miteinander wärmeübertragend zu koppeln, wobei das Verhältnis der Wärmekapazität des Wärmespeicherelements (3) zur Wärmekapazität der Messzelle (1) mindestens 2:1, vorzugsweise mindestens 5:1 ist, umfassend die Schritte:

   a) Messen der Stoffeigenschaften der Messprobe bei einer Messtemperatur,
   b) vor und/oder während Schritt a): Abkühlen, im wärmeübertragend von der Messzelle (1) entkoppelten Zustand, des Wärmespeicherelements (3) mit Hilfe des Temperierungselements (2),
   c) nach Schritt a) und b): Reduzieren des Wärmeleitwiderstandes zwischen dem Wärmespeicherelement (3) und der Messzelle (1), um das Wärmespeicherelement (3) und die Messzelle (1) miteinander wärmeübertragend zu koppeln,
   d) ununterbrochene Wärmeübertragung von der Messzelle (1) auf das Wärmespeicherelement (3), wobei die Messprobe von der Messtemperatur auf eine für die Entnahme der Messprobe geeignete Temperatur gekühlt wird,
   e) Entnahme der Messprobe.

2. Verfahren nach Anspruch 1, **dadurch gekennzeichnet, dass** das Verhältnis der Wärmekapazität des Wärmespeicherelements (3) zur Wärmekapazität der Messzelle (1) ggf. samt Messprobe so gewählt wird, dass die Temperatur des Wärmespeicherelements (3) am Ende von Schritt d) 200°C, vorzugsweise 160°C, besonders bevorzugt 120°C nicht überschreitet.

3. Verfahren nach Anspruch 1 oder 2, **dadurch gekennzeichnet, dass** die Mittel zur Änderung des Wärmeleitwiderstandes einen Antrieb zum Bewegen des Wärmespeicherelements (3), der Messzelle (1) und/oder eines zwischen diesen angeordneten Wärmeübertragungselements (5) zwischen einer ersten Position, in der das Wärmespeicherelement (3) und die Messzelle (1) in wärmeleitendem Kontakt stehen, und einer zweiten Position, in der das Wärmespeicherelement (3) und die Messzelle (1) voneinander wärmeleitend getrennt sind, umfassen.

4. Verfahren nach Anspruch 1, 2 oder 3, **dadurch gekennzeichnet, dass** ein das Wärmespeicherelement (3) und die Messzelle (1) miteinander verbindender Fluid-, insbesondere Flüssigkeitskreislauf als Wärmeübertragungselement (5) vorgesehen ist und dass die Mittel zur Änderung des Wärmeleitwiderstandes eine im Fluidkreislauf angeordnete Pumpe (7) umfassen.

5. Verfahren nach einem der Ansprüche 1 bis 4, **dadurch gekennzeichnet, dass** das Temperierungselement (2) ein thermo-elektrisches Element, insbesondere ein Peltier-Element umfasst oder als solches ausgebildet ist.

6. Verfahren nach einem der Ansprüche 1 bis 5, **dadurch gekennzeichnet, dass** die Vorrichtung zur Messung des Flammpunktes einer flüssigen oder festen Messprobe, insbesondere eines Erdölprodukts, ausgebildet ist, wobei die Messzelle (1) eine Messkammer zur Aufnahme der Messprobe umfasst, welche vorzugsweise aus einer Messwanne sowie einem Deckel gebildet ist und welche mit einer eine Funkenstrecke aufweisenden elektrischen Zündung, wenigstens einem Temperaturfühler und einer Druckmesseinrichtung versehen ist, wobei weiters eine Steuervorrichtung zum Steuern der Temperierungseinrichtung (2), der Zündung und der Anpressvorrichtung und zum Erfassen der Messwerte der Temperaturfühler und der Druckmesseinrichtung vorgesehen ist.

**Claims**

1. A method for measuring material properties of a test sample and subsequently cooling the test sample using a device for controlling the temperature of a test sample in a measuring unit for measuring material properties of the test sample, comprising a measuring cell (1) for receiving the test sample, at least one temperature controlling element (2), and a thermal storage element (3) coupled to the temperature controlling element (2) to transfer heat, wherein means are provided for changing the thermal resistance between the thermal storage element (3) and the measuring cell (1) in order to selectively couple or decouple the thermal storage element (3) and the measuring cell (1) in terms of heat transfer, wherein the ratio of the thermal capacity of the thermal storage element (3) to the thermal capacity of the measuring cell (1) is at least 2:1, preferably at least 5:1, comprising the steps of

   a) measuring the material properties of the test sample at a measuring temperature;
   b) before and/or during step a): cooling the thermal storage element (3) in the state decoupled from the measuring cell (1) in terms of heat transfer, by using the temperature controlling element (2);
   c) after steps a) and b): reducing the thermal resistance between the thermal storage element (3) and the measuring cell (1) in order to couple the thermal storage element (3) and the measuring cell (1) to transfer heat;
   d) continuously transferring heat from the measuring cell (1) to the thermal storage element (3), whereby the test sample is cooled from the measuring temperature to a temperature suitable for removing the test sample; and
   e) removing the test sample.

2. A method according to claim 1, **characterized in that** the ratio of the thermal capacity of the thermal storage element (3) to the thermal capacity of the measuring cell (1), optionally plus test sample, is selected such that the temperature of the thermal storage element (3) at the end of step d) does not exceed 200°C, preferably 160°C, particularly preferably 120°C.

3. A method according to claim 1 or 2, **characterized in that** the means for changing the thermal resistance comprise a drive for moving the thermal storage element (3), the measuring cell (1) and/or an interposed heat transfer element (5) between a first position, in which the thermal storage element (3) and the measuring cell (1) are in thermoconductive contact, and a second position, in which the thermal storage element (3) and the measuring cell (1) are thermoconductively separated from each other.

4. A method according to claim 1, 2 or 3, **characterized in that** a fluid cycle, in particular a liquid cycle, connecting the thermal storage element (3) and the measuring cell (1) is provided as heat transfer element (5), and that the means for changing the thermal resistance comprise a pump (7) disposed in the fluid cycle.

5. A method according to any one of claims 1 to 4, **characterized in that** the temperature controlling element (2) comprises a thermoelectric element, in particular a Peltier element, or is designed as such an element.

6. A method according to any one of claims 1 to 5, **characterized in that** the device is designed for measuring the flash point of a fluid or solid test sample, in particular a petroleum product, wherein the measuring cell (1) comprises a measuring chamber for receiving the test sample, which is preferably comprised of a measuring tub and a lid and which is provided with an electric igniter including a spark gap, at least one temperature sensor, and a pressure measuring device, wherein a control device for controlling the temperature control device (2), the igniter and the contacting device and for detecting the measurements of the temperature sensor and the pressure measuring device is further provided.

**Revendications**

1. Procédé pour mesurer les propriétés inhérentes d'un échantillon à mesurer, puis refroidir l'échantillon à mesurer au moyen d'un dispositif de mise en température d'un échantillon à mesurer dans un dispositif de mesure pour mesurer les propriétés inhérentes de l'échantillon à mesurer comportant une cellule de mesure (1) pour recevoir l'échantillon à mesurer, au moins un élément de mise en température (2) et un élément réservoir thermique (3) couplé à l'élément de mise en température (2) en termes d'échange de chaleur, dans lequel des moyens de modification de la résistance thermique entre l'élément réservoir thermique (3) et la cellule de mesure (1) sont prévus pour assurer sélectivement le découplage entre l'élément réservoir thermique (3) et la cellule de mesure (1) en termes d'échange de chaleur, ou leur couplage en termes d'échange de chaleur, dans lequel le rapport entre la capacité thermique de l'élément réservoir thermique (3) et la capacité thermique de la cellule de mesure (1) est au moins égal à 2:1, de préférence au moins égal à 5:1, comprenant les étapes suivantes:

a) mesure des propriétés inhérentes de l'échantillon à mesurer à une température de mesure,
b) avant et/ou pendant l'étape a): refroidissement, à l'état découplé en termes d'échange de chaleur de la cellule de mesure (1), de l'élément réservoir thermique (3) à l'aide de l'élément de mise en température (2),
c) après l'étape a) et b): réduction de la résistance thermique entre l'élément réservoir thermique (3) et la cellule de mesure (1), afin de coupler l'élément réservoir thermique (3) avec la cellule de mesure (1) en termes d'échange de chaleur,
d) transfert de chaleur continu de la cellule de mesure (1) à l'élément réservoir thermique (3), dans lequel l'échantillon à mesurer est refroidi de la température de mesure jusqu'à une température appropriée pour le prélèvement de l'échantillon à mesurer,
e) prélèvement de l'échantillon à mesurer.

2. Procédé selon la revendication 1, **caractérisé en ce que** le rapport entre la capacité thermique de l'élément réservoir thermique (3) et la capacité thermique de la cellule de mesure (1), le cas échéant avec l'échantillon à mesurer, est choisi de telle sorte que la température de l'élément réservoir thermique (3) à la fin de l'étape d) ne dépasse pas 200°C, de préférence 160°C, de manière particulièrement préférée 120°C.

3. Procédé selon la revendication 1 ou 2, **caractérisé en ce que** les moyens de modification de la résistance thermique comprennent un entraînement pour déplacer l'élément réservoir thermique (3), la cellule de mesure (1) et/ou un élément de transfert de chaleur (5) disposé entre ceux-ci, entre une première position, dans laquelle l'élément réservoir thermique (3) et la cellule de mesure (1) sont en contact en termes de conduction thermique, et une deuxième position, dans laquelle l'élément réservoir thermique (3) et la cellule de mesure (1) sont séparés l'un de l'autre en termes de conduction thermique.

4. Procédé selon la revendication 1, 2 ou 3, **caractérisé en ce qu'un** circuit de fluide, notamment un circuit de liquide, connectant l'élément réservoir thermique (3) à la cellule de mesure (1), est prévu comme élément de transfert de chaleur (5) et **que** les moyens de modification de la résistance thermique comportent une pompe (7) disposée dans le circuit de fluide.

5. Procédé selon l'une des revendications 1 bis 4, **caractérisé en ce que** l'élément de mise en température (2) comprend un élément thermoélectrique, en particulier un élément Peltier, ou est conçu comme tel.

6. Procédé selon l'une des revendications 1 bis 5, **caractérisé en ce que** le dispositif est agencé pour mesure le point d'éclair d'un échantillon à mesurer liquide ou solide, en particulier d'un produit pétrolier, dans lequel la cellule de mesure (1) comporte une chambre de mesure pour recevoir l'échantillon à mesurer, qui est de préférence formée d'un plateau de mesure et d'un couvercle, et qui est pourvue d'un allumage électrique comprenant un éclateur, au moins un capteur de température et un dispositif de mesure de pression, dans lequel un dispositif de commande est en outre prévu pour commander le dispositif de mise en température (2), l'allumage et le dispositif de pressage et pour enregistrer les valeurs mesurées des capteurs de température et du dispositif de mesure de pression.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 540886 B1
- WO 2012017009 A1